# DEMANDE DE BREVET EUROPEEN

(11) **EP 4 726 940 A1**
(43) Date de publication de la demande: **15.04.2026**
(21) Numéro de dépôt: 25207273.1
(22) Date de dépôt: 07.10.2025
(51) Int. Cl.: H02B 1/28, H05K 9/00, H05K 5/02, H02B 1/30

(54) **CAISSON MODULAIRE D'ACCUEIL ET DE PROTECTION D'ÉQUIPEMENTS**

(30) Priorité: 08.10.2024 FR 2410842
(71) Demandeur: THALES, 92190 Meudon (FR)
(72) Inventeur: CHUPIN, Edouard, 49309 Cholet (FR); BOBINET, Christophe, 49309 Cholet (FR); MOAL, Ludovic, 49309 Cholet (FR); RAVAUT, Yannick, 49309 Cholet (FR)
(74) Mandataire: Lavoix

(57) **Abrégé**

La présente invention concerne un caisson (10) pour l'accueil et la protection d'équipements électroniques, électromécaniques et/ou électro-fluidiques, comprenant :
- une ossature (20) parallélépipédique comportant des longerons, des traverses et des montants ;
- au moins une housse (40) étanche montée sur l'ossature (20) pour délimiter une enceinte (12) destinée à accueillir les équipements électroniques, électromécaniques et/ou électro-fluidiques, l'au moins une housse (40) comprenant une nappe (42).

L'au moins une housse (40) est montée de façon amovible sur l'ossature (20).

## Description

La présente invention concerne un caisson pour l'accueil et la protection d'équipements électroniques, électromécaniques et/ou électro-fluidiques, comprenant :
- une ossature parallélépipédique comportant des longerons, des traverses et des montants ;
- au moins une housse étanche montée sur l'ossature pour délimiter une enceinte destinée à accueillir les équipements électroniques, électromécaniques et/ou électro-fluidiques, l'au moins une housse comprenant une nappe.

Un tel caisson est également appelé caisson tactique.

Un tel caisson est par exemple destiné à être déployé dans des environnements dits sévères, tels que par exemple des jungles, des déserts, des environnements polaires. De tels environnements sont dits sévères car ils présentent notamment des conditions météorologiques qui augmentent le risque de pannes des équipements électroniques, électromécaniques et/ou électro-fluidiques que le caisson est destiné à protéger. Par exemple, le taux d'humidité, la présence de sable et/ou de poussières ainsi que la température ambiante peuvent être dans certaines situations néfastes à l'électronique.

En outre, un tel caisson est destiné à subir des contraintes mécaniques substantielles, notamment du type vibration et/ou chocs. Ces contraintes mécaniques augmentent également le risque de pannes des équipements que le caisson est destiné à protéger.

De nos jours, il est connu que de tels caissons soient fabriqués spécifiquement pour des conditions prédéterminées. Les caissons intègrent donc certains équipements en fonction de ces conditions. Un tel caisson n'est donc pas utilisable dans un autre environnement que celui qui était prévu au moment de la conception du caisson.

Un but de l'invention est alors de proposer un caisson capable d'être utilisé dans différents environnements présentant des conditions variées, ledit caisson étant aisément adaptable en fonction des besoins.

A cet effet, l'invention a pour objet un caisson du type susmentionné, dans lequel l'au moins une housse est montée de façon amovible sur l'ossature.

Gâce à l'invention, le caisson est modulaire. L'au moins une housse est montable ou démontable en fonction des besoins. Cela permet d'adapter le caisson en fonction des conditions qui seront rencontrées sur le terrain. En cas de besoin d'une housse, celle-ci sera montée sur l'ossature. Lorsque la housse n'est pas nécessaire (et par exemple pour augmenter les échanges thermiques entre les équipements et l'extérieur du caisson), la housse peut être enlevée.

Suivant d'autres aspects avantageux de l'invention, le caisson comprend une ou plusieurs des caractéristiques suivantes, prises isolément ou suivant toutes les combinaisons techniquement possibles :
- l'ossature comprend une pluralité d'organes mécaniques de connexion reliant les longerons, les traverses et les montants aux sommets du parallélépipède formé par l'ossature ;
- les organes mécaniques de connexion comprennent au moins un élément d'amortissement configuré pour amortir les chocs subis par le caisson ;
- l'au moins une housse comprend une pluralité d'organes d'amortissement agencés de sorte que les organes d'amortissement s'étendent aux sommets du parallélépipède formé par l'ossature lorsque l'au moins une housse est montée sur l'ossature ;
- les organes d'amortissement comprennent chacun au moins un élément de gerbage configuré pour permettre l'empilement du caisson sur un caisson auxiliaire sensiblement identique au caisson ou l'empilement du caisson auxiliaire sur le caisson ;
- les organes d'amortissement sont montés de façon amovible sur la nappe de l'au moins une housse ;
- la nappe de l'au moins une housse comporte :
   - une couche d'aspect destinée à camoufler au moins partiellement le caisson; et/ou
   - une couche de faradisation destinée à protéger l'enceinte d'ondes électromagnétiques extérieures au caisson et à empêcher l'émission d'ondes depuis l'intérieur de l'enceinte vers l'extérieur de l'enceinte ; et/ou
   - une couche d'isolation thermique destinée à réduire les échanges thermiques entre l'enceinte et l'extérieure du caisson ;
- l'au moins une housse comprend au moins un organe d'accrochage destiné à permettre le maintien du caisson en position dans son environnement par accrochage de l'au moins un organe d'accrochage ;
- l'au moins une housse comprend une première portion et une deuxième portion agençables entre :
   - une configuration assemblée dans laquelle la première portion et la deuxième portion sont agencées sur l'ossature et reliées par un mécanisme de fermeture étanche afin de délimiter l'enceinte ;
   - une configuration désassemblée dans laquelle la première portion et la deuxième portion sont à l'écart l'une de l'autre ;
- l'au moins une housse comprend au moins une façade comportant un rabat, le rabat étant déplaçable entre :
   - une configuration déployée dans laquelle le rabat recouvre un orifice d'accès à l'enceinte ;
   - une configuration rétractée dans laquelle le rabat s'étend à l'écart de l'orifice d'accès pour permettre un accès à l'enceinte.

L'invention apparaîtra plus clairement à la lecture de la description qui va suivre, donnée uniquement à titre d'exemple non limitatif, et faite en référence aux dessins dans lesquels :
[Fig. 1] la figure 1 est une illustration schématique simplifiée d'une ossature de caisson selon l'invention ;
[Fig. 2] la figure 2 est une illustration schématique simplifiée du caisson de la figure 1, dans laquelle une housse est montée sur l'ossature de la figure 1 ;
[Fig. 3] la figure 3 est une illustration schématique simplifiée d'une nappe de la housse de la figure 2, en section transversale.

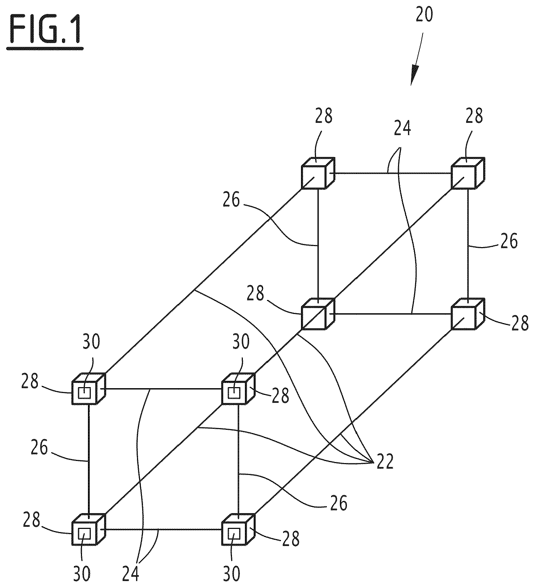

En référence aux figures 1 à 3, on divulgue un caisson 10 selon l'invention.

Le caisson 10 est destiné à l'accueil et la protection d'équipements électroniques, électromécaniques et/ou électro-fluidiques. Par exemple, le caisson 10 est destiné à accueillir des équipements du type IT (« *Information Technology »* en anglais).

Par exemple, de tels équipements ont des dimensions standards, notamment au format 19 pouces. Notamment, de tels équipements respectent la norme IEC 60297-3-108:2014 et/ou la norme DIN 41494-8 et/ou la norme EIA 310-D.

De tels équipements nécessitent par exemple une protection contre l'eau et/ou une protection contre le sable et la poussière et/ou une protection contre la chaleur ou le froid et/ou une protection contre les chocs. Lorsqu'ils sont déployés dans certains environnement, de tels équipements nécessitent également par exemple d'être camouflés pour rendre plus difficile leur détection visuelle.

Le caisson 10 est destiné à fournir ces protections. En outre, le caisson 10 est soumis à une contrainte de masse importante puisqu'un tel caisson doit être aisément transportable par un opérateur.

Le caisson 10 comprend une ossature 20 et au moins une housse 40.

Le caisson 10 est conforme à la norme STANAG 4370 de l'OTAN.

L'ossature 20 est parallélépipédique.

L'ossature 20 confère au caisson 10 sa forme (celle d'un parallélépipède, notamment d'un parallélépipède rectangle ou pavé droit) et sa tenue mécanique.

L'ossature 20 comporte des longerons 22, des traverses 24 et des montants 26. Avantageusement, les longerons 22, les traverses 24 et les montants 26 forment les côtés du parallélépipède formé par l'ossature 20.

Par exemple, les longerons 22 et/ou les traverses 24 et/ou les montants 26 sont des profilés, notamment formés par un matériau métallique, présentant une section droite en forme de L. En variante, la section des profilés est autre, par exemple carré, rectangulaire, circulaire, en forme de U, etc.

Avantageusement, les longerons 22 comprennent un assemblage mécanique télescopique permettant d'adapter la longueur des longerons 22 en fonction des besoins.

Par exemple, l'ossature 20 comporte en outre une pluralité d'organes mécaniques de connexion 28 reliant les longerons 22, les traverses 24 et les montants 26 aux sommets du parallélépipède formé par l'ossature 20. En particulier, comme illustré sur la figure 1, les organes mécaniques de connexion 28 forment les sommets du parallélépipède formé par l'ossature 20.

Notamment, chaque organe mécanique de connexion 28 relie un longeron 22 avec une traverse 24 et un montant 26.

Avantageusement, chaque organe mécanique de connexion 28 est monté de manière amovible sur les longerons 22, les traverses 24 et les montants 26. Chaque organe mécanique de connexion 28 est ainsi remplaçable en cas de besoin. Par exemple, lorsqu'un opérateur souhaite remplacer un ou plusieurs organe(s) mécanique(s) de connexion 28, il le (ou les) remplace un par un, la structure globale de l'ossature 20 étant maintenue parallélépipédique par les organes mécaniques de connexion 28 restant montés.

Avantageusement, les organes mécaniques de connexion 28 comprennent au moins un élément d'amortissement 30 configuré pour amortir les chocs et les chutes subis par le caisson 10. Par exemple, l'au moins un élément amortissement 30 est formé par un matériau architecturé ou fusible et est destiné à être déformé lorsqu'une certaine force est appliquée sur l'ossature 20 pour absorber l'énergie du choc.

Par exemple, chaque organe mécanique de connexion 28 comprend au moins un élément d'amortissement 30.

Par exemple, chaque organe mécanique de connexion 28 comprend des éléments de connexion du type boulons, vis, etc. Les éléments de connexion coopèrent notamment avec les longerons 22, traverses 24 et montants 26 pour les relier entre eux.

L'au moins une housse 40 est étanche. L'au moins une housse 40 présente notamment un indice de protection IP65 selon la norme EN 60529.

L'au moins une housse 40 est montée sur l'ossature 20 pour délimiter une enceinte 12 du caisson 10, destinée à accueillir les équipements électroniques, électromécaniques et/ou électro-fluidiques. En particulier, le caisson 10 est dépourvu de tout autre élément d'enveloppement délimitant l'enceinte 12.

Notamment, l'au moins une housse 40 recouvre, en particulier entièrement, l'ossature 20.

En particulier, l'au moins une housse 40 est apte à entièrement recouvrir l'enceinte 12.

L'au moins une housse 40 est montée de manière amovible sur l'ossature 20.

L'au moins une housse 40 comprend une nappe 42.

Avantageusement, l'au moins une housse 40 comprend une première portion 50 et une deuxième portion 52.

Encore avantageusement, l'au moins une housse 40 comprend au moins une façade 56 comportant un rabat 58.

Encore avantageusement, l'au moins une housse 40 comprend en outre une pluralité d'organes d'amortissement 62.

Encore avantageusement, l'au moins une housse 40 comprend au moins un organe d'accrochage 66.

Par exemple, la nappe 42 comporte :
- une couche d'aspect 44 destinée à camoufler au moins partiellement le caisson 10 ; et/ou
- une couche de faradisation 46 destinée à protéger l'enceinte 12 d'ondes électromagnétiques extérieures au caisson 10 et à empêcher l'émission d'ondes depuis l'intérieur de l'enceinte 12 vers l'extérieur de l'enceinte 12 ; et/ou
- une couche d'isolation thermique 48 destinée à réduire les échanges thermiques entre l'enceinte 12 et l'extérieure du caisson 10.

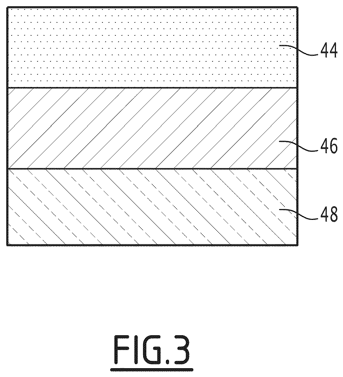

Dans l'exemple de la figure 3, la nappe 42 comporte une couche d'aspect 44, une couche de faradisation 46 et une couche d'isolation thermique 48. Bien entendu, l'invention concerne également les caissons 10 dans lesquels la nappe 42 comporte l'une ou plusieurs des couches 44, 46, 48 selon les différentes combinaisons possibles. L'invention concerne également les caissons 10 dans lesquels une même couche de la nappe 42 présente une fonction d'aspect et/ou une fonction de faradisation et/ou une fonction d'isolation thermique.

Avantageusement, la nappe 42 est dans un état de précontrainte. En outre, par exemple, la nappe 42 présente en tout point une contrainte de traction suivant deux directions de trame et de chaine de fibres composant la nappe 42, et une double courbure inverse.

La nappe 42 présente par exemple une résistance à la rupture selon la norme EN ISO 1421 et selon des directions de chaînes et trames de la nappe 42 entre 600 daN/5cm et 1 200 daN/5cm, notamment entre 800 daN/5cm et 1 000 daN/5cm, en particulier dans un état précontraint.

Encore avantageusement, la nappe 42 est étanche. En particulier, la nappe 42 présente un indice de protection IP65 selon la norme EN 60529.

La première portion 50 de la housse 40 comprend notamment une première portion de nappe 42.

La deuxième portion 52 de la housse 40 comprend notamment une deuxième portion de nappe 42.

La première portion 50 et la deuxième portion 52 de housse 40 sont agençables entre :
- une configuration assemblée dans laquelle la première portion 50 et la deuxième portion 52 de housse 40 sont agencées sur l'ossature 20 et reliées par un mécanisme de fermeture étanche 54 de la housse 40 afin de délimiter l'enceinte 12 ;
- une configuration désassemblée dans laquelle la première portion 50 et la deuxième portion 52 de housse 40 sont à l'écart l'une de l'autre.

Par exemple, le mécanisme de fermeture étanche 54 comprend une fermeture à glissière, une fermeture à pression, une fermeture autoagrippante ou autre.

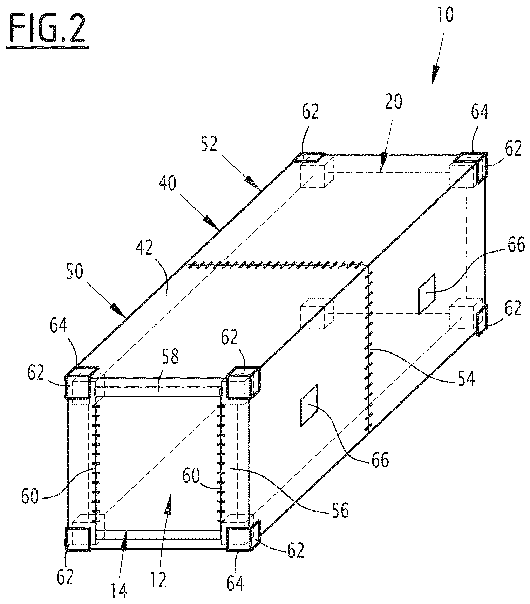

Par exemple, comme illustré sur la figure 2, la première portion 50 de housse 40 forme une première moitié de parallélépipède et la deuxième portion 52 de housse 40 forme une deuxième moitié de parallélépipède complémentaire de la première moitié de parallélépipède, les première et deuxième moitiés de parallélépipède étant séparées par un plan parallèle à l'au moins une façade 56.

L'au moins une façade 56 de la housse 40 comportant le rabat 58 forme par exemple une petite face du parallélépipède formé par le caisson 10. Par « petite face », on entend que le parallélépipède est un parallélépipède rectangle (ou pavé droit), et que la petite face est une des deux faces les plus petites du pavé droit. En particulier, les petites faces du parallélépipède sont agencées en regard de portions des équipements formant des interfaces avec l'opérateur, c'est-à-dire des portions d'équipements avec lesquelles l'opérateur est destiné à interagir par exemple pour l'entretien, la réparation et/ou le réglage de l'équipement.

Le rabat 58 est avantageusement une portion de nappe 42 déplaçable entre :
- une configuration déployée dans laquelle le rabat 58 recouvre un orifice 14 d'accès à l'enceinte 12 ;
- une configuration rétractée (figure 2) dans laquelle le rabat 58 s'étend à l'écart de l'orifice d'accès 14 pour permettre un accès à l'enceinte 12.

Ainsi, en manipulant le rabat 58, l'opérateur peut aisément avoir accès aux équipements et en particulier aux portions des équipements formant interface avec l'opérateur.

Par exemple, comme illustré sur la figure 2, le rabat 58 est enroulable de sorte que dans la configuration déployée, le rabat 58 soit déroulé sur l'orifice d'accès 14 et dans la configuration rétractée, le rabat 58 soit enroulé à l'écart de l'orifice d'accès 14.

Selon un exemple particulier, deux façades opposées de la housse 40 comportent chacun un tel rabat.

Avantageusement, la housse 40 comprend en outre un mécanisme de fermeture 60 étanche configuré pour permettre le maintien du rabat 58 dans la configuration déployée.

La présence d'un tel rabat 58 permet de se passer d'un couvercle amovible, susceptible d'être perdu lorsqu'il est ôté.

Avantageusement, les organes d'amortissement 62 sont agencés de sorte que les organes d'amortissement 62 s'étendent aux sommets du parallélépipède formé par l'ossature 20 lorsque l'au moins une housse 40 est montée sur l'ossature 20.

Notamment, les organes d'amortissement 62 sont destinés à être interposés entre l'ossature 20 et une surface sur laquelle repose le caisson 10 ou entre l'ossature 20 et des objets aux alentours du caisson 10 et avec lequel le caisson 10 est susceptible d'entrer en contact. Ainsi, les organes d'amortissement 62 sont configurés pour absorber les chocs entre le caisson 10, notamment l'ossature 20, et la surface sur laquelle repose le caisson 10 ou entre le caisson 10, notamment l'ossature 20, et d'autres objets entourant le caisson 10.

Par exemple, les organes d'amortissement 62 comprennent chacun au moins un élément de gerbage 64 configuré pour permettre l'empilement du caisson 10 sur un caisson auxiliaire sensiblement identique au caisson 10 ou l'empilement du caisson auxiliaire sur le caisson 10. Par exemple, l'élément de gerbage 64 est une surface sensiblement plane et présentant une structure antidérapante. Notamment, l'élément de gerbage 64 présente une géométrie mâle ou femelle et permet par interaction d'un élément de gerbage 64 à géométrie mâle d'un premier caisson et d'un élément de gerbage 64 à géométrie femelle d'un deuxième caisson, d'assurer une superposition stable du deuxième caisson sur le premier caisson.

Avantageusement, les organes d'amortissement 62 sont réalisés en un matériau d'amortissement, par exemple en matériau élastomère.

Encore avantageusement, les organes d'amortissement 62 comprennent au moins un élément d'amortissement configuré pour amortir les chocs subis par le caisson 10. Par exemple, l'au moins un élément amortissement 62 est formé par un matériau architecturé ou fusible et est destiné à être déformé pour absorber l'énergie des chocs.

Par exemple, le matériau architecturé est obtenu par impression 3D. Notamment, le matériau architecturé permet, par sa géométrie, d'absorber l'énergie mécanique par flambement local de mailles du matériau.

En variante, les organes d'amortissement 62 sont formés par une couche de mousse ou par une pluralité de couches de mousse superposées, chaque couche ayant une dureté différente. Une telle superposition de couches permet de couvrir un spectre vibratoire d'intérêt en comparaison aux profils vibratoires auxquels est soumis le caisson 10.

Encore avantageusement, les organes d'amortissement 62 sont montés de façon amovible sur la nappe 42 de l'au moins une housse 40.

Par exemple, les organes d'amortissement 62 sont clipsables et déclipsables sur la nappe 42 de l'au moins une housse 40.

L'au moins un organe d'accrochage 66 est avantageusement destiné à permettre le maintien du caisson 10 en position dans son environnement. Par exemple, l'au moins un organe d'accrochage 66 est un anneau sur lequel est attachable une corde d'attache.

Optionnellement, une ou plusieurs poignées sont attachées sur la housse 40, par exemple cousues sur la housse 40. Ces poignées permettent de faciliter le transport du caisson 10, par exemple en permettant un arrimage du caisson, notamment dans le contexte d'un transport dans un aéronef. Par exemple, les poignées sont réalisées en un matériau textile, notamment un matériau textile comprenant des fibres de polyéthylène, par exemple le Dyneema^{®}.

Grâce à l'invention, le caisson 10 peut être adapté aisément pour convenir aux besoins variés imposés par des environnements différents dans lequel le caisson 10 est destiné à être déployé.

Les organes mécaniques de connexion 28 de l'ossature 20, la nappe 42 de la housse 40 et les organes d'amortissement 62 de la housse 40 sont montés de manière amovible si bien qu'ils peuvent être aisément remplacés en cas de besoin.

Cela permet de moduler le caisson 10 pour optimiser son poids et son encombrement en fonction des besoins, sans nécessiter de fabriquer une multitude de caissons adaptés pour chaque situation.

## Revendications

1. Caisson (10) pour l'accueil et la protection d'équipements électroniques, électromécaniques et/ou électro-fluidiques, comprenant :
- une ossature (20) parallélépipédique comportant des longerons (22), des traverses (24) et des montants (26);
- au moins une housse (40) étanche montée sur l'ossature (20) pour délimiter une enceinte (12) destinée à accueillir les équipements électroniques, électromécaniques et/ou électro-fluidiques, l'au moins une housse (40) comprenant une nappe (42) ;
**caractérisé en ce que** l'au moins une housse (40) est montée de façon amovible sur l'ossature (20).

2. Caisson (10) selon la revendication 1, dans lequel l'ossature (20) comprend une pluralité d'organes mécaniques de connexion (28) reliant les longerons (22), les traverses (24) et les montants (26) aux sommets du parallélépipède formé par l'ossature (20).

3. Caisson (10) selon la revendication 2, dans lequel les organes mécaniques de connexion (28) comprennent au moins un élément d'amortissement (30) configuré pour amortir les chocs subis par le caisson (10).

4. Caisson (10) selon l'une quelconque des revendications précédentes, dans lequel l'au moins une housse (40) comprend une pluralité d'organes d'amortissement (62) agencés de sorte que les organes d'amortissement (62) s'étendent aux sommets du parallélépipède formé par l'ossature (20) lorsque l'au moins une housse (40) est montée sur l'ossature (20).

5. Caisson (10) selon la revendication 4, dans lequel les organes d'amortissement (62) comprennent chacun au moins un élément de gerbage (64) configuré pour permettre l'empilement du caisson (10) sur un caisson auxiliaire sensiblement identique au caisson (10) ou l'empilement du caisson auxiliaire sur le caisson (10).

6. Caisson (10) selon la revendication 4 ou 5, dans lequel les organes d'amortissement (62) sont montés de façon amovible sur la nappe (42) de l'au moins une housse (40).

7. Caisson (10) selon l'une quelconque des revendications précédentes, dans lequel la nappe (42) de l'au moins une housse (40) comporte :
- une couche d'aspect (44) destinée à camoufler au moins partiellement le caisson (10) ; et/ou
- une couche de faradisation (46) destinée à protéger l'enceinte (12) d'ondes électromagnétiques extérieures au caisson (10) et à empêcher l'émission d'ondes depuis l'intérieur de l'enceinte (12) vers l'extérieur de l'enceinte (12) ; et/ou
- une couche d'isolation thermique (48) destinée à réduire les échanges thermiques entre l'enceinte (12) et l'extérieure du caisson (10).

8. Caisson (10) selon l'une quelconque des revendications précédentes, dans lequel l'au moins une housse (40) comprend au moins un organe d'accrochage (66) destiné à permettre le maintien du caisson (10) en position dans son environnement par accrochage de l'au moins un organe d'accrochage (66).

9. Caisson (10) selon l'une quelconque des revendications précédentes, dans lequel l'au moins une housse (40) comprend une première portion (50) et une deuxième portion (52) agençables entre :
- une configuration assemblée dans laquelle la première portion (50) et la deuxième portion (52) sont agencées sur l'ossature (20) et reliées par un mécanisme de fermeture étanche (54) afin de délimiter l'enceinte (12) ;
- une configuration désassemblée dans laquelle la première portion (50) et la deuxième portion (52) sont à l'écart l'une de l'autre.

10. Caisson (10) selon l'une quelconque des revendications précédentes, dans lequel l'au moins une housse (40) comprend au moins une façade (56) comportant un rabat (58), le rabat (58) étant déplaçable entre :
- une configuration déployée dans laquelle le rabat (58) recouvre un orifice (14) d'accès à l'enceinte ;
- une configuration rétractée dans laquelle le rabat (58) s'étend à l'écart de l'orifice d'accès (14) pour permettre un accès à l'enceinte (12).
